# EUROPEAN PATENT APPLICATION

(11) **EP 4 633 317 A1**
(43) Date of publication of application: **15.10.2025**
(21) Application number: 25167206.9
(22) Date of filing: 28.03.2025
(51) Int. Cl.: H10B 41/27, G11C 5/14, H10B 41/40, H10B 43/27, H10B 43/40, H10D 1/66, H10D 1/68, G11C 5/02

(54) **SEMICONDUCTOR DEVICES AND DATA STORAGE SYSTEMS INCLUDING THE SAME**

(30) Priority: 12.04.2024 KR 20240049465
(71) Applicant: Samsung Electronics Co., Ltd., Suwon-si, Gyeonggi-do 16677 (KR)
(72) Inventor: YUN, Kangoh, 16677 Suwon-si (KR); LEE, Yunjo, 16677 Suwon-si (KR); LEE, Dongjin, 16677 Suwon-si (KR); LEE, Jaeduk, 16677 Suwon-si (KR)
(74) Representative: Marks & Clerk LLP

(57) **Abstract**

A semiconductor device (100) may include: a first semiconductor structure (S1) including a first substrate (201), first circuit elements (220) on the first substrate, first circuit interconnection lines (280) on the first circuit elements, and a first peripheral region insulating layer (290); a second semiconductor structure (S2) including a first region of a second substrate (301) on the first semiconductor structure, second circuit elements (320) on the first region of the second substrate, and second circuit interconnection lines (380) on the second circuit elements; a capacitor structure including a first capacitor electrode (284P) spaced apart from the first circuit interconnection lines on a lower surface of the second substrate, a second region of the second substrate facing the first capacitor electrode, and a first through-via extending (TSV1) in the second substrate and electrically connected to the first capacitor electrode; and a third semiconductor structure (S3) including a third substrate on the second semiconductor structure, and memory cells on the third substrate.

## Description

### BACKGROUND

The present disclosure relates generally to semiconductor devices and, more particularly, to data storage systems including the same.

In a data storage system requiring data storage, a semiconductor device capable of storing high-capacity data is required. Accordingly, a semiconductor device capable of storing high-capacity data is required. Accordingly, a manner of increasing the data storage capacity of semiconductor devices has been researched. For example, as one method of increasing the data storage capacity of a semiconductor device, a semiconductor device including memory cells arranged three-dimensionally instead of memory cells arranged two-dimensionally has been proposed.

### SUMMARY

An aspect of the present disclosure is to provide a semiconductor device having improved integration.

Another aspect of the present disclosure is to provide a data storage system including a semiconductor device having improved integration.

A semiconductor device according to example embodiments of the present disclosure may include: a first semiconductor structure including a first substrate, first circuit elements on the first substrate, first circuit interconnection lines on the first circuit elements, and a first peripheral region insulating layer on the first circuit interconnection lines; a second semiconductor structure including a first region of a second substrate on the first semiconductor structure, second circuit elements on the first region of the second substrate, and second circuit interconnection lines on the second circuit elements; a capacitor structure including a first capacitor electrode spaced apart from the first circuit interconnection lines on a lower surface of the second substrate, a second region of the second substrate facing the first capacitor electrode, and a first through-via penetrating through (e.g., extending in) the second substrate and connected to the first capacitor electrode; and a third semiconductor structure including a third substrate on the second semiconductor structure and the capacitor structure, and memory cells on the third substrate.

A semiconductor device according to example embodiments of the present disclosure may include: a first substrate; first circuit elements on the first substrate; circuit interconnection lines on the first circuit elements; a passive element structure including a conductive layer spaced apart from the circuit interconnection lines; a peripheral region insulating layer on the circuit interconnection lines and the conductive layer; a second substrate on the peripheral region insulating layer; first through-vias penetrating through (e.g., extending in) the second substrate and connected to the conductive layer; and second through-vias passing through the second substrate and connected to the circuit interconnection lines.

A data storage system according to example embodiments of the present disclosure may include: a semiconductor storage device including a first semiconductor structure including a first substrate, first circuit elements on the first substrate, and a first circuit interconnection structure on the first circuit elements; a second semiconductor structure including a second substrate on the first semiconductor structure, second circuit elements on the second substrate and a second circuit interconnection structure on the second circuit elements; a third semiconductor structure on the second semiconductor structure and including memory cells; a passive element structure including a conductive layer on a lower surface of the second substrate and a through-via penetrating through (e.g., extending in) the second substrate and connected to the conductive layer; and an input/output pad electrically connected to the first and second circuit elements; and a controller electrically connected to the semiconductor storage device through the input/output pad and configured to control the semiconductor storage device.

A semiconductor device with improved integration and a data storage system including the same may be provided by stacking second semiconductor structures including a second substrate on a first semiconductor structure including a first substrate, and including a passive element structure including a conductive layer on a lower surface of the second substrate.

Advantages and effects of the present application are not limited to the foregoing content and may be more easily understood in the process of describing a specific example embodiment of the present disclosure.

Advantages and effects of the present application may be variously extended without departing from the scope of the present disclosure.

At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings, wherein like reference numerals (when used) indicate corresponding elements throughout the several views, and in which:
FIG. 1 is a schematic block diagram of a semiconductor device according to example embodiments;
FIG. 2 is a circuit diagram illustrating a charge pump circuit included in a voltage generator of a semiconductor device according to example embodiments;
FIG. 3 is a schematic perspective view of a semiconductor device according to example embodiments;
FIGS. 4A and 4B are schematic plan views of a semiconductor device according to example embodiments;
FIG. 5 is a schematic cross-sectional view of a semiconductor device according to example embodiments;
FIGS. 6A to 6C are schematic plan views of a semiconductor device according to example embodiments;
FIG. 7 is a schematic cross-sectional view of a semiconductor device according to example embodiments;
FIG. 8 is a schematic cross-sectional view of a semiconductor device according to example embodiments;
FIGS. 9A to 9I are schematic cross-sectional views for describing a method of manufacturing a semiconductor device according to example embodiments;
FIG. 10 is a view schematically illustrating a data storage system including a semiconductor device according to example embodiments;
FIG. 11 is a perspective view schematically illustrating a data storage system including a semiconductor device according to an example embodiment; and
FIG. 12 is a cross-sectional view schematically illustrating a semiconductor package according to an example embodiment.

### DETAILED DESCRIPTION

Hereinafter, example embodiments of the present disclosure will be described with reference to the accompanying drawings.

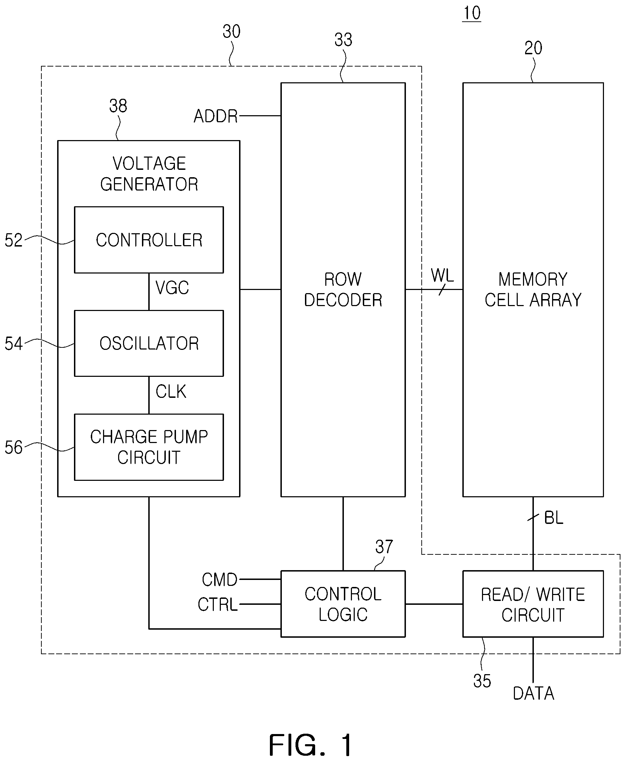

FIG. 1 is a schematic block diagram of a semiconductor device according to example embodiments.

Referring to FIG. 1, a semiconductor device 10 may include a memory cell array 20 and a peripheral circuit 30 operatively coupled to the memory cell array 20. The semiconductor device 10 may be a memory device, and may be, for example, a non-volatile memory such as a flash memory, or the like, or a volatile memory such as a dynamic random access memory (DRAM), a static random access memory (SRAM), or the like.

The memory cell array 20 may include a plurality of memory cells. The plurality of memory cells may be connected to a row decoder 33 through a plurality of word lines WL, and may be connected to a read/write circuit 35 through bit lines BL. In example embodiments, a plurality of memory cells arranged along the same column are connected to the same word line WL, and a plurality of memory cells arranged along the same row may be connected to the same bit line BL. In some example embodiments, the memory cell array 20 may include a plurality of memory blocks, and each of the memory blocks may include a plurality of memory cells.

The peripheral circuit 30 may receive an address ADDR, a command CMD, and a control signal CTRL from outside the semiconductor device 10, and may transmit and receive data DATA with a device external to the semiconductor device 10. The peripheral circuit 30 may include the row decoder 33, the read/write circuit 35, a control logic 37, and a voltage generator 38 configured to generate various voltages required for an operation. According to example embodiments, the peripheral circuit 30 may further include various sub-circuits (not explicitly shown), such as an input/output circuit and an error correction circuit for correcting errors in data DATA read from the memory cell array 20.

The control logic 37 may be coupled to the row decoder 33, the voltage generator 38, and the read/write circuit 35. The control logic 37 may control an overall operation of the semiconductor device 10. The control logic 37 may generate various internal control signals used within the semiconductor device 10 in response to the control signal CTRL. For example, the control logic 37 may adjust a voltage level provided to the word lines WL and bit lines BL when performing a memory operation such as a program operation or an erase operation.

The row decoder 33 may select some of the plurality of memory cells in response to the address ADDR, and may select at least one word line WL. The row decoder 33 may transmit a voltage for performing a memory operation to the selected word line WL.

The read/write circuit 35 may be connected to the memory cell array 20 through the bit lines BL. The read/write circuit 35 may include a writer driver or a sense amplifier. Specifically, during a program operation, the read/write circuit 35 may operate as a write driver and apply a voltage according to the data DATA to be stored in the memory cell array 20 to the bit lines BL. Meanwhile, during a read operation, the read/write circuit 35 operates as a sense amplifier and may sense data DATA stored in the memory cell array 20.

The voltage generator 38 may include a controller 52, an oscillator 54, and a charge pump circuit 56.

The charge pump circuit 56 may include a plurality of charge pumps, and each of the plurality of charge pumps may include at least one switch element and at least one pumping capacitor. An output voltage of the charge pump circuit 56 may be used for an operation of the semiconductor device 10. For example, the row decoder 33 may use the output voltage of the charge pump circuit 56 to input a bias voltage to the word line WL to perform a program operation, an erase operation, a read operation, or the like.

The controller 52 may control an operation of the oscillator 54. For example, the controller 52 may determine a frequency of a clock signal CLK that the oscillator 54 outputs to the charge pump circuit 56, based on at least one of process, voltage and/or temperature (PVT) information of the semiconductor device 10 and a target level of a voltage to be output by the charge pump circuit 56. For example, when the charge pump circuit 56 includes a plurality of charge pumps, a selected charge pump that actually operates, among the plurality of charge pumps, may be determined by the controller 52.

The oscillator 54 may output a clock signal CLK that turns on or turns off at least one switch element included in the charge pump circuit 56. The clock signal CLK output by the oscillator 54 may be determined in response to a control signal VGC from the controller 52. For example, the oscillator 54 may set a frequency and a swing range (e.g., voltage amplitude) of the clock signal CLK differently depending on the control signal VGC transmitted by the controller 52.

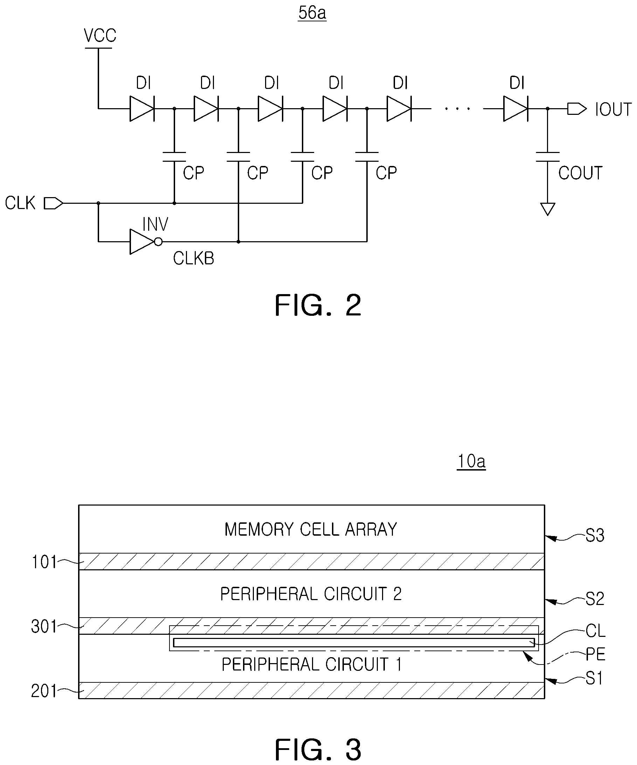

FIG. 2 is a circuit diagram illustrating a charge pump circuit included in a voltage generator of a semiconductor device according to example embodiments.

Referring to FIG. 2, a charge pump circuit 56a may include a plurality of diodes DI, a plurality of pumping capacitors CP, and an output capacitor COUT. The plurality of diodes DI may be connected to each other in series, cathode-to-anode, and the plurality of pumping capacitors CP may be connected to nodes between adjacent pairs of diodes in the plurality of diodes DI. A first diode may receive a power supply voltage VCC having a predetermined level, and a last diode may transmit an output current IOUT to an output node. The output capacitor COUT may be connected between the output node and ground.

Each of the plurality of pumping capacitors CP may be charged or discharged by a clock signal CLK or a complementary clock signal CLKB phase-converted to have an opposite phase to the clock signal CLK by an inverter INV. For example, odd-numbered pumping capacitors CP may be charged or discharged by the clock signal CLK, and even-numbered pumping capacitors CP may be charged or discharged by the complementary clock signal CLKB.

FIG. 3 is a schematic cross-sectional view of a semiconductor device according to example embodiments.

Referring to FIG. 3, a semiconductor device 10a may include first to third semiconductor structures S1, S2 and S3 and a passive element structure PE. The first to third semiconductor structures S1, S2 and S3 may be sequentially stacked in a vertical direction (i.e., a direction perpendicular to an upper surface of the first semiconductor structure S1). Each of the first to third semiconductor structures S1, S2 and S3 may extend along a plane parallel to a horizontal plane (e.g. a plane that runs parallel to an upper surface of the first semiconductor structure S1). The passive element structure PE may be disposed between the first semiconductor structure S1 and the second semiconductor structure S2. According to the explanation, the passive element structure PE may be described as being disposed across the first semiconductor structure S1 and the second semiconductor structure S2. In some example embodiments, the third semiconductor structure S3 may be disposed below the first and second semiconductor structures S1 and S2.

The first and second semiconductor structures S1 and S2 and the passive element structure PE may include peripheral circuits configured to drive memory cells, and may be a region in which the peripheral circuit 30 of FIG. 1 is disposed. The third semiconductor structure S3 may be a region in which the memory cell array 20 of FIG. 1 is disposed. The first semiconductor structure S1 may include a first substrate 201, the second semiconductor structure S2 may include a second substrate 301, and the third semiconductor structure S3 may include a third substrate 101.

The passive element structure PE may include a passive element, for example, at least one of a resistor, an inductor, or a capacitor. The passive element structure PE may include a conductive layer CL, and the conductive layer CL may be disposed below the second substrate 301. In some example embodiments, the passive element structure PE may further include a partial region of the second substrate 301. In some example embodiments, the passive element structure PE may include a pumping capacitor CP included in the charge pump circuits 56 and 56a of FIGS. 1 and 2. In this case, the conductive layer CL may be a capacitor electrode of the pumping capacitor CP.

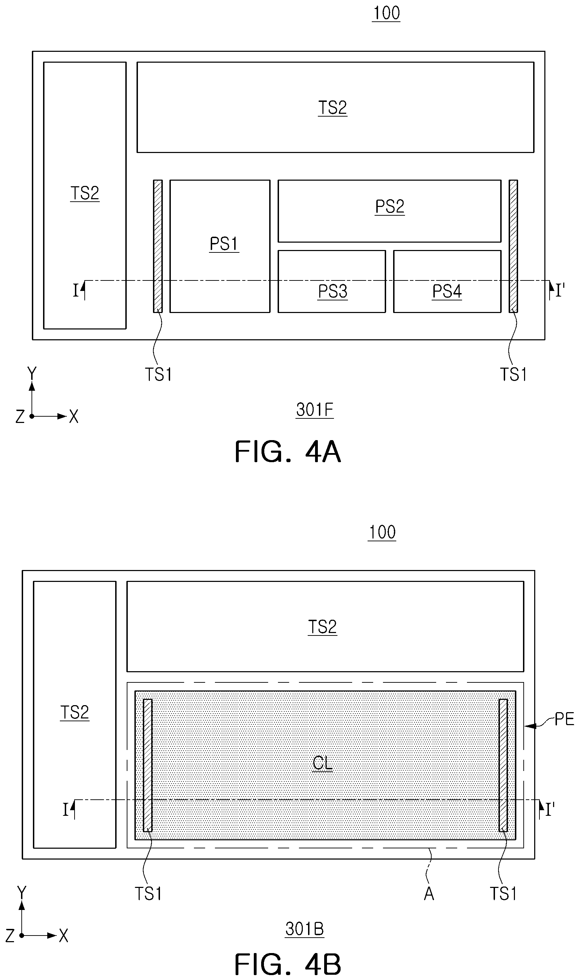

FIGS. 4A and 4B are schematic plan views of a semiconductor device according to example embodiments. FIG. 4A illustrates an example embodiment of a layout on an upper surface 301F of the second substrate 301 of FIG. 3, and FIG. 4B illustrates an example embodiment of a layout on a lower surface 301B of the second substrate 301 of FIG. 3. The terms "upper" and "lower", as used herein, may refer to relative positions in a vertical direction (e.g. in a direction perpendicular to a surface (e.g. an upper surface) of one or more of the substrates).

Referring to FIG. 4A, in a semiconductor device 100, first to fourth circuit regions PS1, PS2, PS3 and PS4, first through-via regions TS1, and second through-via regions TS2 may be disposed on the upper surface 301F of the second substrate 301

The first to fourth circuit regions PS1, PS2, PS3 and PS4 may be regions in which circuit elements performing different functions are arranged. However, in example embodiments, the number, the relative size, and the specific arrangement form of the first to fourth circuit regions PS1, PS2, PS3 and PS4 may be variously changed.

The first through-via regions TS1 may be spaced apart from each other. The first through-via regions TS1 may be regions in which first through-vias penetrating through the second substrate 301 and connected to the conductive layer CL (see FIG. 3) are disposed. For example, the first through-vias may be arranged in one row or a plurality of rows in each of the first through-via regions TS1. The second through-via regions TS2 may be regions in which through-vias penetrating through the second substrate 301 and electrically connected to circuit elements of the first semiconductor structure S1 (see FIG. 3) are disposed. The term "connected" (or "connecting," or like terms, such as "contact" or "contacting"), as may be used herein, is intended to refer to a physical and/or electrical connection between two or more elements, and may include other intervening elements. As used herein, the term "and/or" includes any and all combinations of one or more of the associated listed items. In example embodiments, the number, the size, and the arrangement of the second through-via regions TS2 relative to the first to fourth circuit regions PS1, PS2, PS3 and PS4 may be variously changed. For example, in some example embodiments, circuit regions may be further disposed outside the second through-via regions TS2.

Referring to FIG. 4B, in the semiconductor device 100, first through-via regions TS1, second through-via regions TS2, and a conductive layer CL may be disposed on the lower surface 301B of the second substrate 301.

Since the through-vias extend by penetrating through the second substrate 301, the first through-via regions TS1 and the second through-via regions TS2 on the lower surface 310B of the second substrate 301 may be disposed to correspond to the first through-via regions TS1 and the second through-via regions TS2 on the upper surface 301F of the second substrate 301, respectively.

The conductive layer CL may be disposed to overlap the first through-via regions TS1. The term "overlap" (or "overlapping," or like terms), as may be used herein, is intended to broadly refer to a first element that intersects with at least a portion of a second element in the vertical direction (i.e., Z-direction), but does not require that the first and second elements be completely aligned with one another in a horizontal plane (i.e., X-direction and/or Y-direction). The conductive layer CL may form a passive element structure PE along with through-vias of the first through-via regions TS1. In an example embodiment, the passive element structure PE may be a capacitor structure, and the conductive layer CL may be an electrode of the capacitor. The conductive layer CL may be disposed in a region which vertically overlaps the first to fourth circuit regions PS1, PS2, PS3 and PS4 on the upper surface 301F of the second substrate 301. In some embodiments, the conductive layer CL may be disposed in a region which vertically overlaps some of the first to fourth circuit regions PS1, PS2, PS3 and PS4. The conductive layer CL may be arranged in a rectangular shape, but the shape of the conductive layer CL in plan view is not limited thereto. In some example embodiments, the conductive layer CL may have an oval, polygon, or line shape.

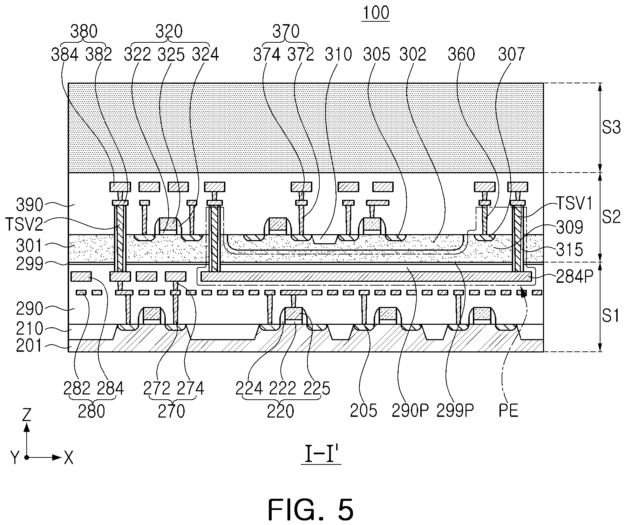

FIG. 5 is a schematic cross-sectional view of a semiconductor device according to example embodiments. FIG. 5 illustrates a cross-section taken along section line I-I' of FIGS. 4A and 4B.

Referring to FIG. 5, a cross-section of the first and second semiconductor structures S1 and S2 and the passive element structure PE of the semiconductor device 100 according to an example embodiment is illustrated. In FIG. 5, a cross-section of the third semiconductor structure S3 is omitted for clarity purposes and therefore is not described herein.

The first semiconductor structure S1 may include a first substrate 201, first source/drain regions 205 and first device isolating layers 210 (e.g., shallow trench isolation (STI) structures) in the first substrate 201, first circuit elements 220 disposed on the first substrate 201, a first peripheral region insulating layer 290, first circuit contact plugs 270, first circuit interconnection lines 280 and a first bonding insulating layer 299.

The first substrate 201 may have an upper surface extending in an X-direction and a Y-direction. An active region may be defined on the first substrate 201 by first device isolating layers 210. The first source/drain regions 205 including impurities may be disposed in a portion of the active region. The first substrate 201 may include a semiconductor material, such as a group IV semiconductor, a group III-V compound semiconductor, or a group II-VI compound semiconductor. The first substrate 201 may be provided as a bulk wafer or an epitaxial layer.

The first circuit elements 220 may include planar transistors. Each of the first circuit elements 220 may include a first circuit gate dielectric layer 222, a first spacer layer 224, and a first circuit gate electrode 225. The first source/drain regions 205 may be disposed in the first substrate 201 on both sides of the first circuit gate electrode 225.

The first peripheral region insulating layer 290 may cover the first circuit elements 220, the first circuit contact plugs 270, and the first circuit interconnection lines 280 on the first substrate 201. The term "cover" (or "covering," "covers," or like terms), as may be used herein, is intended to broadly refer to an element, structure or layer that is on or over another element, structure or layer, either directly or with one or more other intervening elements, structures or layers therebetween. The first peripheral region insulating layer 290 may include a plurality of insulating layers formed in different process operations. The first peripheral region insulating layer 290 may be formed of an insulating material.

The first circuit contact plugs 270 and the first circuit interconnection lines 280 may be included in a first circuit interconnection structure electrically connected to the first circuit elements 220 and the first source/drain regions 205. The first circuit contact plugs 270 may have a cylindrical shape, and the first circuit interconnection lines 280 may have a line shape, although embodiments are not limited thereto. An electrical signal may be applied to the first circuit elements 220 through the first circuit contact plugs 270 and the first circuit interconnection lines 280. The first circuit interconnection lines 280 may include first lower circuit interconnection lines 282 and first upper circuit interconnection lines 284. The first circuit contact plugs 270 may include first lower circuit contact plugs 272 connected to the first source/drain regions 205, and the first circuit gate electrodes 225, and first upper circuit contact plugs 274 connecting the first lower circuit interconnection lines 282 and the first upper circuit interconnection lines 284. The first lower circuit interconnection lines 282 may be connected to the first lower circuit contact plugs 272, and the first upper circuit interconnection lines 284 may be connected to the first upper circuit contact plugs 274.

The first circuit contact plugs 270 and the first circuit interconnection lines 280 may include a conductive material, and may include, for example, tungsten (W), copper (Cu), aluminum (Al), or the like, and each of components may further include a diffusion barrier. In example embodiments, the number of layers of the first circuit contact plugs 270 and the first circuit interconnection lines 280 may be variously changed.

The first bonding insulating layer 299 may be disposed on the first peripheral region insulating layer 290. The first bonding insulating layer 299 may be a layer for bonding the first semiconductor structure S1 and the second semiconductor structure S2 together. The first bonding insulating layer 299 may include, for example, at least one of SiN, SiON, SiCN, SiOC, SiOCN, or SiO.

The second semiconductor structure S2 may include a first region of a second substrate 301, second device isolating layers 310 in the first region of the second substrate 301, second circuit elements 320 disposed on the second substrate 301, a second peripheral region insulating layer 390, second circuit contact plugs 370, second circuit interconnection lines 380, a second through-via TSV2, and a via insulating layer 315. The first region of the second substrate 301 may include a well region 302 and second source/drain regions 305.

The second substrate 301 may have an upper surface extending in an X-direction and a Y-direction. An active region may be defined on the second substrate 301 by the second device isolating layers 310. A well region 302 including impurities may be disposed in a portion of the active region of the second substrate 301, and the second source/drain regions 305 including impurities may be disposed in the well region 302. The well region 302 may be arranged to surround at least the second circuit elements 320 disposed on a first capacitor electrode 284P of a passive element structure PE. However, the arrangement position of the well region 302 is not limited thereto. The term "surround" " (or "surrounds," or like terms), as may be used herein, is intended to broadly refer to an element, structure or layer that extends around, envelops, encircles, or encloses another element, structure or layer on all sides, although breaks or gaps may also be present. Thus, for example, a material layer having voids or gaps therein may still "surround" another layer which it encircles. The second substrate 301 may include a semiconductor material, such as a group IV semiconductor, a group III-V compound semiconductor, or a group II-VI compound semiconductor. The second substrate 301 may be provided as a bulk wafer or an epitaxial layer.

The second circuit elements 320 may include planar transistors. Each of the second circuit elements 320 may include a second circuit gate dielectric layer 322, a second spacer layer 324, and a second circuit gate electrode 325. The second source/drain regions 305 may be disposed in the second substrate 301 on both sides of the second circuit gate electrode 325.

The second peripheral region insulating layer 390 may cover the second circuit elements 320, the second circuit contact plugs 370, and the second circuit interconnection lines 380 on the second substrate 301. The second peripheral region insulating layer 390 may be formed of an insulating material. In some example embodiments, the second peripheral region insulating layer 390 may include a bonding insulating layer disposed on an uppermost portion.

The second circuit contact plugs 370 and second circuit interconnection lines 380 may be included in a second circuit interconnection structure electrically connected to the second circuit elements 320 and the second source/drain regions 305. An electrical signal may be applied to the second circuit elements 320 through the second circuit contact plugs 370 and the second circuit interconnection lines 380. The second circuit contact plugs 370 may include a second lower circuit contact plugs 372 connected to the second source/drain regions 305 and the second circuit gate electrodes 325, and second upper circuit contact plugs 374 connecting second lower circuit interconnection lines 382 and second upper circuit interconnection lines 384. The second circuit interconnection lines 380 may include the second lower circuit interconnection lines 382 connected to the second lower circuit contact plugs 372 and the second upper circuit interconnection lines 384 connected to second upper circuit contact plugs 374.

The second through-via TSV2 may electrically and physically connect the second circuit interconnection lines 380 of the second semiconductor structure S2 and the first circuit interconnection lines 280 of the first semiconductor structure S1. The second through-via TSV2 may be electrically connected to the first circuit elements 220. The second through-via TSV2 may extend into the first semiconductor structure S1 by penetrating through the second substrate 301. The second through-via TSV2 may be electrically separated (e.g. insulated) from the second substrate 301 by the via insulating layer 315.

The second circuit contact plugs 370, the second circuit interconnection lines 380, and the second through-via TSV2 may include a conductive material, and may include, for example, tungsten (W), copper (Cu), aluminum (Al), or the like, and each of the components may further include a diffusion prevention layer. In example embodiments, the number of layers of the second circuit contact plugs 370 and the second circuit interconnection lines 380 may be variously changed.

The via insulating layer 315 may include an insulating material such as silicon oxide or silicon nitride. In example embodiments, the positions of an upper end and a lower end of the via insulating layer 315 and the thicknesses thereof may be variously changed.

The passive element structure PE may include a first capacitor electrode 284P, a second capacitor electrode 309, and first and second capacitor dielectric regions 290P and 299P between the first capacitor electrode 284P and the second capacitor electrode 309. The passive element structure PE may further include first through-vias TSV1 and a capacitor contact plug 360. The first through-vias TSV1 may be connected to the first capacitor electrode 284P.

The first capacitor electrode 284P may correspond to the conductive layer CL in FIG. 4B and may be disposed below a lower surface of the second substrate 301. The first capacitor electrode 284P may be a conductive layer closest to a lower surface of the first region of the second substrate 301. No other conductive material may be interposed between the first capacitor electrode 284P and the second substrate 301. The first capacitor electrode 284P may be spaced apart from the first circuit interconnection structure. The first capacitor electrode 284P may be disposed on substantially the same level as the second upper circuit interconnection lines 284 disposed in an uppermost portion among the first circuit interconnection lines 280, on the first peripheral region insulating layer 290. The term "level" when used in reference to position (e.g. "the same level") may refer to a relative position in the vertical direction (e.g. Z-direction). The first capacitor electrode 284P may be spaced apart from the second upper circuit interconnection lines 284 in a horizontal direction. The first capacitor electrode 284P may be formed together with the second upper circuit interconnection lines 284, and thus may include the same material and have substantially the same thickness as the second upper circuit interconnection lines 284. An entire lower surface of the first capacitor electrode 284P may be covered with the first peripheral region insulating layer 290. That is, the entirety of the lower surface of the first capacitor electrode 284P may be covered by the first peripheral region insulating layer 290.

The second capacitor electrode 309 may be a second region of the second substrate 301. The second region of the second substrate 301 may include a region facing the first capacitor electrode 284P in the second substrate 301, and may include a region on a lower surface of the well region 302. The second region of the second substrate 301 may further include a contact region 307 disposed in the second substrate 301 up to a predetermined depth from an upper surface of the second substrate 301. The second capacitor electrode 309 may include impurities. For example, the contact region 307 may include impurities of the same conductivity type as the other regions of the second capacitor electrode 309 at different (e.g. higher) concentrations. In some example embodiments, an impurity region for blocking an electric field may be further disposed between the second capacitor electrode 309 and the well region 302.

The first and second capacitor dielectric regions 290P and 299P may be arranged in parallel with the first peripheral region insulating layer 290 and the bonding insulating layer 299, respectively. The first capacitor dielectric region 290P may be formed along with the first peripheral region insulating layer 290, and the second capacitor dielectric area 299P may be formed along with the bonding insulating layer 299. By way of explanation, the first and second capacitor dielectric regions 290P and 299P may be described as regions disposed between the first capacitor electrode 284P and the second capacitor electrode 309 among the first peripheral region insulating layer 290 and the bonding insulating layer 299, respectively. That is, the first capacitor dielectric region 290P may be a portion of the first peripheral region insulating layer 290 that is located between the first capacitor electrode 284P and the second capacitor electrode 309, and the second capacitor dielectric region 299P may be a region of the bonding insulating layer 299 that is located between the first capacitor electrode 284P and the second capacitor electrode 309.

The first through-vias TSV1 may electrically and physically connect the second circuit interconnection structure and the first capacitor electrode 284P. The first through-vias TSV1 may extend to a level of the first semiconductor structure S1 by penetrating through the second substrate 301. The first through-vias TSV1 may be electrically separated (e.g. insulated) from the second substrate 301 by the via insulating layer 315. For example, the first through-vias TSV1 may be connected to both ends of the first capacitor electrode 284P in one direction, for example, the X-direction. However, in example embodiments, the arrangement position, the arrangement form, and the number of the first through-vias TSV1 may be variously changed. In each of the first through-vias TSV1, a width of an upper surface thereof, in a horizontal direction parallel to the upper surface of the first substrate 201, may be greater than a width of a lower surface thereof.

The capacitor contact plug 360 may be connected to the contact region 307 to apply an electrical signal to the second capacitor electrode 309. The first through-vias TSV1 and the capacitor contact plug 360 may receive different voltages, so that the first capacitor electrode 284P and the second capacitor electrode 309 may receive different voltages. For example, the second capacitor electrode 309 may receive a ground voltage through the capacitor contact plug 360. The capacitor contact plug 360 may be electrically insulated from the first through vias TSV1. The capacitor contact plug 360 may be disposed on the same level as the second lower circuit contact plugs 372.

The first through-vias TSV1 and the capacitor contact plug 360 may be connected to the second lower circuit interconnection lines 382 of the second semiconductor structure S2. Upper surfaces of the first through-vias TSV1 and the capacitor contact plug 360 may be disposed on substantially the same level. The upper surfaces may be disposed on substantially the same level as upper surfaces of the second lower circuit contact plugs 372. However, in some example embodiments, upper surfaces of the first through-vias TSV1 may be disposed on a different level from a level of the upper surfaces of the second lower circuit contact plugs 372. For example, the upper surfaces of the first through-vias TSV1 may be disposed on the same level as upper surfaces of the second lower circuit interconnection lines 382. The first through-vias TSV1 and the capacitor contact plug 360 may include a conductive material, and may include, for example, tungsten (W), copper (Cu), aluminum (Al), or the like, and each of the components may further include a diffusion barrier.

As described above, the passive element structure PE of this example embodiment may be a capacitor structure including a capacitor, and may be a metal-oxide-semiconductor (MOS) capacitor in which the second capacitor electrode 309 is formed of a semiconductor material. In some example embodiments, the passive element structure PE may include a plurality of capacitors.

As described with reference to FIGS. 4A to 5, in the semiconductor device 100, the first capacitor electrode 284P may be disposed on the lower surface of the second substrate 301 and may be connected to the second circuit interconnection structure on the upper surface of the second substrate 301 through the first through-vias TSV1. Accordingly, as compared to the case in which the first capacitor electrode 284P is disposed on the upper surface of the second substrate 301, the areas of the first to fourth circuit regions PS1, PS2, PS3 and PS4 on the upper surface of the second substrate 301 may be expanded, thereby improving integration.

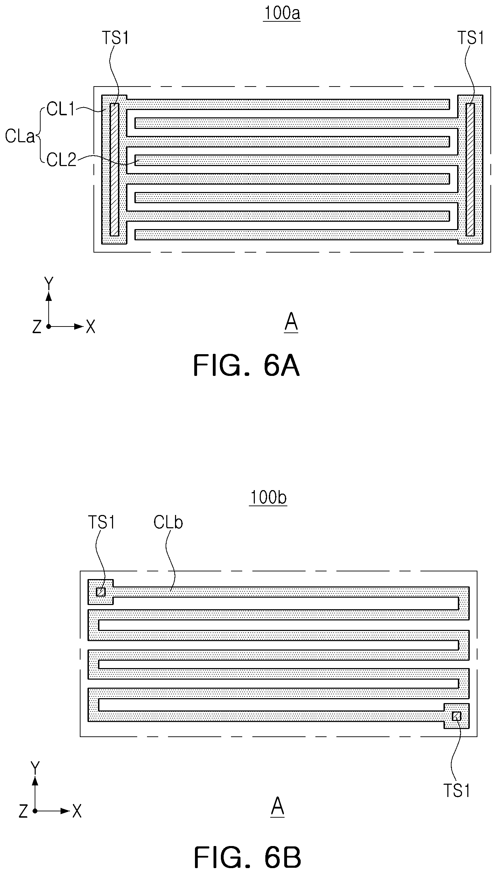

FIGS. 6A to 6C are schematic plan views of a semiconductor device according to example embodiments. FIGS. 6A to 6C illustrate a region corresponding to region 'A' in FIG. 4B.

Referring to FIG. 6A, in a semiconductor device 100a, a conductive layer CLa on a lower surface 301B of a second substrate 301 (see FIG. 4B) may include first and second conductive layers CL1 and CL2 spaced apart from each other. The first and second conductive layers CL1 and CL2 may include line patterns arranged alternately in the Y-direction and extending in the X-direction, and connection portions connecting the line patterns and extending in the Y-direction. The connection portions may overlap the first through-via regions TS1. For example, each of the first and second conductive layers CL1 and CL2 may be one electrode of a capacitor. In example embodiments, the relative arrangement form of the first and second conductive layers CL1 and CL2 may be variously changed.

Referring to FIG. 6B, in a semiconductor device 100b, a conductive layer CLb on a lower surface 301B of a second substrate 301 (see FIG. 4B) may have a shape in which a plurality of line patterns are connected in ends thereof and extend as one layer. Both ends of the conductive layer CLb may overlap the first through-via regions TS1. For example, the conductive layer CLb may form a resistor. In example embodiments, the arrangement shape of the conductive layer CLb may be variously changed.

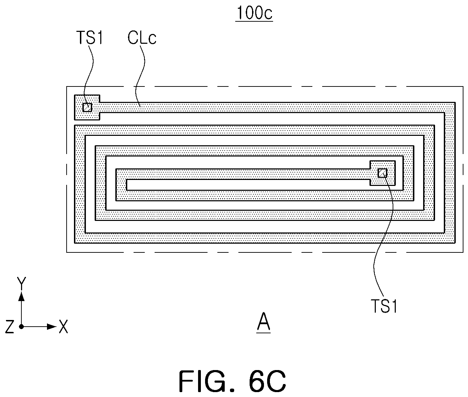

Referring to FIG. 6C, in a semiconductor device 100c, a conductive layer CLc on a lower surface 301B of a second substrate 301 (see FIG. 4B) may be arranged to form a concentric square toward the center of the arranged region. Both ends of the conductive layer CLc may overlap the first through-via regions TS1. For example, the conductive layer CLc may form an inductor. The conductive layer CLc may form a spiral. In example embodiments, the conductive layer CLc may be arranged to form a concentric circle, and the arrangement shape of the conductive layer CLc may be variously changed.

In example embodiments, the passive element structure PE of FIG. 3 may include at least one of the passive elements formed by the conductive layers CLa, CLb, or CLc of the example embodiments of FIGS. 4B and 6A to 6C.

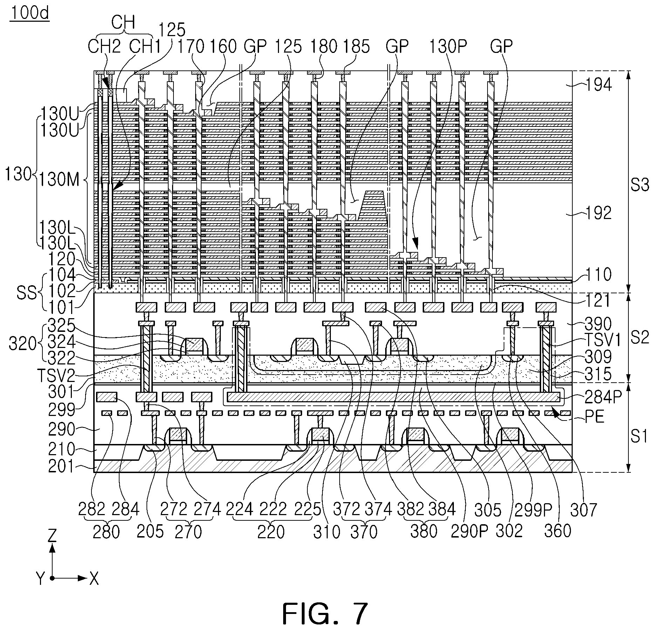

FIG. 7 is a schematic cross-sectional view of a semiconductor device according to example embodiments.

Referring to FIG. 7, in a semiconductor device 100d, the description with reference to FIG. 5 may be equally applied to the first and second semiconductor structures S1 and S2.

The third semiconductor structure S3 may include a source structure SS including a third substrate 101, gate electrodes 130 stacked on the source structure SS and included in a plurality of stepwise regions GP, interlayer insulating layers 120 alternately stacked with the gate electrodes 130, channel structures CH arranged to penetrate through a stack structure of the gate electrodes 130, and cell contact plugs 170 connected to the gate electrodes 130 and extending vertically (i.e., in the Z-direction). The third semiconductor structure S3 may further include a horizontal insulating layer 110 disposed below the gate electrodes 130, substrate insulating layers 121 disposed to penetrate through the third substrate 101, contact insulating layers 160 around the cell contact plugs 170, studs 180 on the channel structures CH and the cell contact plugs 170, cell interconnection lines 185 on the studs 180, and first and second cell region insulating layers 192 and 194 covering the gate electrodes 130.

In this example embodiment, the semiconductor device 100d may be a NAND flash memory device in which memory cells are arranged around channel structures CH in the third semiconductor structure S3.

The source structure SS may include the third substrate 101, a first horizontal conductive layer 102, and a second horizontal conductive layer 104, which are sequentially stacked in the vertical direction. However, in example embodiments, the number of conductive layers of the source structure SS may be variously changed.

The third substrate 101 may function as at least a portion of a common source line. The third substrate 101 may have an upper surface extending in the X-direction and the Y-direction (i.e., in a horizontal plane). The third substrate 101 may include a conductive material. For example, the third substrate 101 may include a semiconductor material, such as a group IV semiconductor, a group III-V compound semiconductor, or a group II-VI compound semiconductor. For example, the group IV semiconductor may include silicon, germanium, or silicon-germanium. The third substrate 101 may further include impurities. The third substrate 101 may be provided as a bulk wafer or an epitaxial layer. In some example embodiments, the third substrate 101 may be provided as a polycrystalline semiconductor layer, such as a polycrystalline silicon layer, or an epitaxial layer. The third substrate 101 may be bonded to the second peripheral region insulating layer 390 or may be formed on the second peripheral region insulating layer 390.

The first and second horizontal conductive layers 102 and 104 may be sequentially stacked and disposed on an upper surface of a third substrate 101. The first horizontal conductive layer 102 may not extend below the plurality of stepwise regions GP, and the second horizontal conductive layer 104 may extend below the plurality of stepwise regions GP. The first horizontal conductive layer 102 may function as a portion of a common source line, and may function as, for example, a common source line with the third substrate 101. The first and second horizontal conductive layers 102 and 104 may include a semiconductor material, and may include, for example, polycrystalline silicon.

The horizontal insulating layer 110 may be disposed on the third substrate 101 on the same level as (i.e., coplanar with) the first horizontal conductive layer 102 below the plurality of stepwise regions GP. The horizontal insulating layer 110 may include a plurality of insulating layers. The horizontal insulating layer 110 may be layers remaining after a portion of the horizontal insulating layer 110 is replaced with the first horizontal conductive layer 102 during a manufacturing process of the semiconductor device 100d. The horizontal insulating layer 110 may include at least one of silicon oxide, silicon nitride, silicon carbide, or silicon oxynitride.

The substrate insulating layers 121 may be disposed to penetrate through the third substrate 101, the horizontal insulating layer 110, and the second horizontal conductive layer 104. The substrate insulating layer 121 may include an insulating material, and may include, for example, silicon oxide, silicon nitride, silicon carbide, or silicon oxynitride.

The gate electrodes 130 may be stacked and vertically spaced apart from each other on the third substrate 101 to form a stack structure together with the interlayer insulating layers 120. The stack structure may include lower and upper stack structures which are vertically stacked. However, according to example embodiments, the stack structure may be formed of a single stack structure.

The gate electrodes 130 may include lower gate electrodes 130L forming a gate of a ground selection transistor, memory gate electrodes 130M of a plurality of memory cells, and upper gate electrodes 130U forming gates of string select transistors. The number of memory gate electrodes 130M of the memory cells may be determined according to the capacity of the semiconductor device 100d. According to an example embodiment, there may be one to four or more upper and lower gate electrodes 130U and 130L, respectively, and the upper and lower gate electrodes 130U and 130L may have a structure identical to or different from a structure of the memory gate electrodes 130M. In example embodiments, the gate electrodes 130 may further include a gate electrode 130 disposed above an upper gate electrodes 130U and/or below a lower gate electrodes 130L and included in an erase transistor used in an erase operation using a gate induced drain leakage (GIDL) current phenomenon. Additionally, a portion of the gate electrodes 130, for example, memory gate electrodes 130M adjacent to the upper or lower gate electrodes 130U and 130L, may be dummy gate electrodes.

The gate electrodes 130 may extend to different lengths in the X-direction to form step structures in the plurality of stepwise regions GP. The gate electrodes 130 may have a shape in which a predetermined depth thereof is removed from an upper portion of any one of the lower and upper stack structures of the gate electrodes 130 in the stepwise regions GP. The stepwise regions GP may be arranged so as not to overlap each other in a Z-direction. On the stepwise region GP of the lower stack structure, at least a portion of the gate electrodes 130 of the upper stack structures may extend horizontally. In example embodiments, the arrangement form, the arrangement order, and the depth of the stepwise regions GP may be variously changed.

The gate electrodes 130 may form first and second step structures in each stepwise region GP in an asymmetric shape in the X-direction. In the first step structure, the gate electrodes 130 may be connected to the cell contact plugs 170, and in the second step structure, the gate electrodes 130 may form a dummy region or dummy structure that is not connected to the cell contact plugs 170. In example embodiments, the specific shape of the step structure, the number of gate electrodes 130 included in each step structure, or the like, is not limited to the shape illustrated in FIG. 7. In some example embodiments, the gate electrodes 130 may be arranged to have a step structure in the Y-direction.

Due to the step structure, in the gate electrodes 130, the lower gate electrode 130 may extend to be longer than the upper gate electrode 130, so that each of the gate electrodes 130 may have regions in which upper surfaces are exposed upwardly from the interlayer insulating layers 120 and other gate electrodes 130, and the regions may be referred to as pad regions 130P. In each of the gate electrode 130, the pad region 130P may be a region including an end of the gate electrode 130 in the X-direction. The gate electrodes 130 may be respectively connected to the cell contact plugs 170 in the pad regions 130P. The gate electrodes 130 may include regions with increased cross-sectional thickness in the pad regions 130P.

The gate electrodes 130 may include a metal material, and may include, for example, tungsten (W). According to an example embodiment, the gate electrodes 130 may include polycrystalline silicon or metal silicide material. In example embodiments, the gate electrodes 130 may further include a diffusion barrier, and the diffusion barrier may include, for example, tungsten nitride (WN), tantalum nitride (TaN), titanium nitride (TiN), or combinations thereof.

The interlayer insulating layers 120 may be disposed between the gate electrodes 130 and may thus be included in a stack structure with the gate electrodes 130. Similarly with the gate electrodes 130, the interlayer insulating layers 120 may be spaced apart from each other in a direction, perpendicular to an upper surface of the third substrate 101, and may be arranged to extend in the X-direction. In the stack structure, relatively thick upper interlayer insulating layers 125 may be disposed on an uppermost portion of the lower and upper stack structures. However, the thickness and shape of the interlayer insulating layers 120 and the upper interlayer insulating layer 125 may be variously changed in embodiments. The interlayer insulating layers 120 and the upper interlayer insulating layer 125 may include an insulating material such as silicon oxide or silicon nitride.

The channel structures CH may be included in one memory cell string, respectively, and may be arranged in rows and columns on the third substrate 101 to be spaced apart from each other. The channel structures CH may be arranged to form a grid pattern or in a zigzag shape in one direction, in an X-Y plane. The channel structures CH have a pillar shape and may have inclined side surfaces that become narrower as they extend vertically toward the third substrate 101 depending on the aspect ratio.

The channel structures CH may include first and second channel structures CH1 and CH2, which are vertically stacked. The channel structures CH may have a shape in which lower first channel structures CH1 and upper second channel structures CH2 are connected, and may have bent portions due to differences in width in a connection region. However, according to example embodiments, the number of channel structures stacked in the Z-direction may be variously changed.

Each of the channel structures CH may include a channel layer and a channel dielectric layer disposed within a channel hole (i.e., opening). The channel layer may be connected to the first horizontal conductive layer 102 in a lower portion thereof. The channel layer may include a semiconductor material such as polycrystalline silicon or single crystalline silicon. The channel dielectric layer may be disposed between the gate electrodes 130 and the channel layer. The channel dielectric layer may include a tunneling layer, a charge storage layer, and a blocking layer which are sequentially stacked from the channel layer.

The cell contact plugs 170 may be connected to contact regions 130P of the gate electrodes 130. The cell contact plugs 170 may penetrate through at least a portion of the cell region insulating layer 190 and may be connected to each of the contact regions 130P of the gate electrodes 130 exposed upwardly. The term "exposed" (or "exposes," or like terms) may be used herein to describe relationships between elements and/or with reference to intermediate processes in fabricating an integrated circuit device, but may not require exposure of a particular element in the completed device. Likewise, the term "not exposed" may be used to describe relationships between elements and/or with reference to intermediate processes in fabricating an integrated circuit device, but may not require a particular element to be unexposed in the completed device. The cell contact plugs 170 may penetrate through the gate electrodes 130 below the contact regions 130P, may penetrate through the second horizontal conductive layer 104, the horizontal insulating layer 110 and the third substrate 101, and may be connected to the second circuit interconnection lines 380 in the second substrate structure S2. Although not specifically illustrated, the cell contact plugs 170 may also have bent portions between the upper and lower portions thereof, similarly to the bent portions between the first and second channel structures CH1 and CH2.

The cell contact plugs 170 may be spaced apart from the gate electrodes 130 below the contact regions 130P by the contact insulating layers 160. The cell contact plugs 170 may be spaced apart from the third substrate 101, the horizontal insulating layer 110, and the second horizontal conductive layer 104 by the substrate insulating layers 121. However, in some example embodiments, the cell contact plugs 170 may be connected to the contact regions 130P without penetrating through the gate electrodes 130. In some example embodiments, a through-via extending into the second semiconductor structure S2 by penetrating through the third substrate 101 may be further disposed outside the gate electrodes 130.

The cell contact plugs 170 may include a conductive material, for example, at least one of tungsten (W), copper (Cu), aluminum (Al), or alloys thereof. In some example embodiments, the cell contact plugs 170 may include a barrier layer (not explicitly shown) extending along a side surface and a bottom surface thereof, and/or may have an air gap therein.

The contact insulating layers 160 may be arranged to surround side surfaces of each of the cell contact plugs 170 below the contact regions 130P. The contact insulating layers 160 may be spaced apart from each other in the Z-direction around each of the cell contact plugs 170. The contact insulating layers 160 may be disposed on substantially the same level as the gate electrodes 130. The contact insulating layers 160 may include an insulating material, and may include, for example, silicon oxide, silicon nitride, or silicon oxynitride.

The studs 180 and the cell interconnection lines 185 may be included in a cell interconnection structure electrically connected to memory cells of the third semiconductor structure S3. The studs 180 may be connected to the channel structures CH and the cell contact plugs 170, and may electrically connect the channel structures CH and the gate electrodes 130 to the cell interconnection lines 185. The studs 180 may have a plug shape, and the cell interconnection lines 185 may have a line shape. In example embodiments, the number of plugs and interconnection lines included in the cell interconnection structure may be variously changed. The studs 180 and the cell interconnection lines 185 may include metal, and may include, for example, tungsten (W), copper (Cu), and aluminum (Al).

The first and second cell region insulating layers 192 and 194 may be disposed to cover the lower and upper stack structures, respectively. Each of the first and second cell region insulating layers 192 and 194 may be formed of an insulating material or may be formed of a plurality of insulating layers.

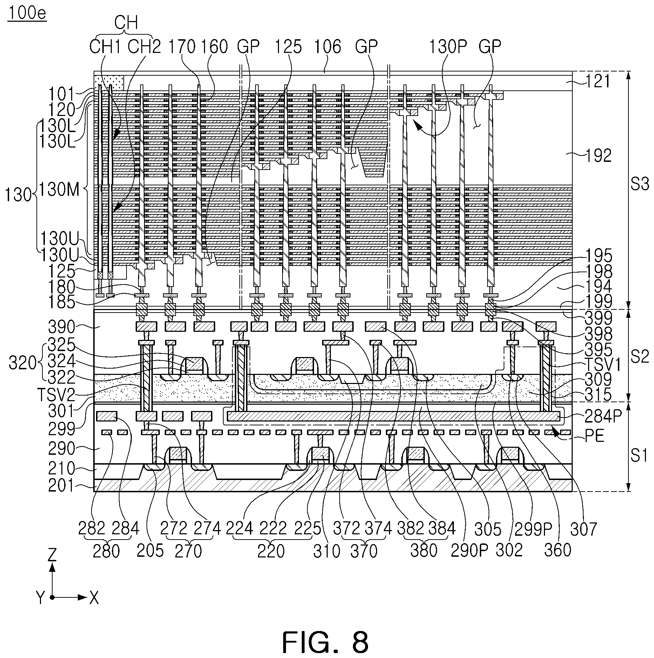

FIG. 8 is a schematic cross-sectional view of a semiconductor device according to example embodiments.

Referring to FIG. 8, in a semiconductor device 100e, a second semiconductor structure S2 and a third semiconductor structure S3 may be bonded by a wafer bonding method.

The description with reference to FIG. 5 may be equally applied to the first and second semiconductor structures S1 and S2. However, the second semiconductor structure S2 may further include second bonding vias 395, second bonding metal layers 398, and second bonding insulating layer 399, which are included in a bonding structure. The second bonding vias 395 may be disposed on second circuit interconnection lines 380 in an uppermost portion and may be electrically connected to the second circuit interconnection lines 380. At least a portion of the second bonding metal layers 398 may be connected to the second bonding vias 395 on the second bonding vias 395. The second bonding metal layers 398 may be connected to the third bonding metal layers 198 of the third semiconductor structure S3. The second bonding metal layers 398, along with the third bonding metal layers 198, may provide an electrical connection path for bonding the second semiconductor structure S2 and the third semiconductor structure S3. The second bonding vias 395 and the second bonding metal layers 398 may include a conductive material, for example, copper (Cu). The second bonding insulating layer 399 may be disposed around the second bonding metal layers 398. The second bonding insulating layer 399 may also function as a diffusion barrier for the second bonding metal layers 398, and may include, for example, at least one of SiN, SiON, SiCN, SiOC, SiOCN, or SiO.

When there is no other description, the description with reference to FIG. 7 may be applied to the third semiconductor structure S3. The third semiconductor structure S3 may further include third bonding vias 195, third bonding metal layers 198, and third bonding insulating layer 199, which are included in the bonding structure. The third semiconductor structure S3 may further include a passivation layer 106 covering an upper surface of a third substrate 101.

The third bonding vias 195 and the third bonding metal layers 198 may be disposed below cell interconnection lines 185 in a lowermost portion. The third bonding vias 195 may connect the cell interconnection lines 185 and the third bonding metal layers 198, and the third bonding metal layers 198 may be bonded to the second bonding metal layers 398 of the second semiconductor structure S2. The third bonding insulating layer 199 may be bonded and connected to the second bonding insulating layer 399 of the second semiconductor structure S2 by bonding. The third bonding vias 195 and the third bonding metal layers 198 may include a conductive material, for example, copper (Cu). The third bonding insulating layer 199 may include, for example, at least one of SiO, SiN, SiCN, SiOC, SiON, or SiOCN.

The second and third semiconductor structures S2 and S3 may be bonded to each other by bonding the second bonding metal layers 398 and the third bonding metal layers 198 and bonding the second bonding insulating layer 399 and the third bonding insulating layer 199. The second and third semiconductor structures S2 and S3 may be bonded by hybrid bonding including copper (Cu)-to-copper (Cu) bonding and dielectric-to-dielectric bonding.

In an example embodiment, the third semiconductor structure S3 may not include the first and second horizontal conductive layers 102 and 104 (see FIG. 7). The channel structures CH may be directly connected to the third substrate 101 in a state in which the channel layers are exposed through an upper end thereof. However, the electrical connection shape of the channel structures CH and the common source line may be variously changed in embodiments, and the channel structures CH and source structures SS may have the same structure as the embodiment of FIG. 7.

The passivation layer 106 may be disposed on the upper surface of the third substrate 101 and may protect the semiconductor device 100e. The passivation layer 106 may include at least one of an insulating material, and may include, for example, silicon oxide, silicon nitride, or silicon carbide.

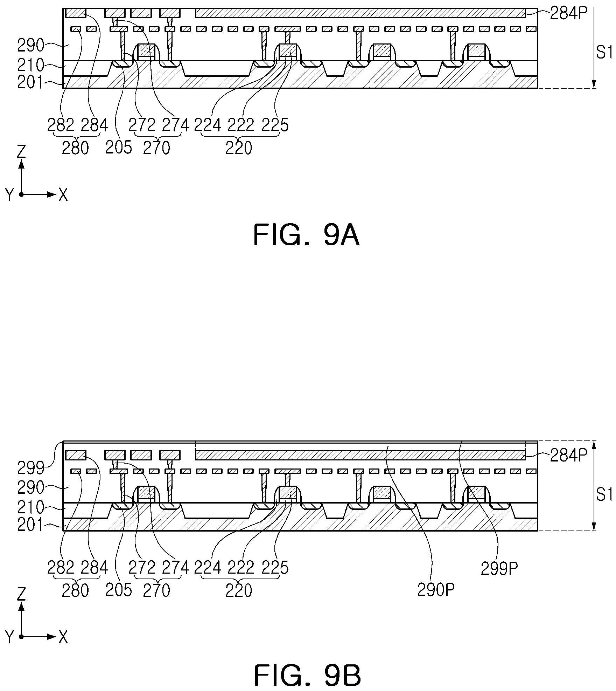

FIGS. 9A to 9I are schematic cross-sectional views depicting intermediate processes in an illustrative method of manufacturing a semiconductor device according to example embodiments. FIGS. 9A to 9I illustrate an embodiment of a method of manufacturing the semiconductor device of FIG. 7, each of which illustrates cross-sections corresponding to FIG. 7.

Referring to FIG. 9A, first circuit elements 220, a first circuit interconnection structure, a first capacitor electrode 284P, and a first peripheral region insulating layer 290 may be formed on a first substrate 201 of a first semiconductor structure S1.

First, the first device isolating layers 210 may be formed in the first substrate 201, and a first circuit gate dielectric layer 222 and a first circuit gate electrode 225 may be sequentially formed on the first substrate 201. The first device isolating layers 210 may be formed by, for example, a shallow trench isolation (STI) process. The first circuit gate dielectric layer 222 and the first circuit gate electrode 225 may be formed using atomic layer deposition (ALD) or chemical vapor deposition (CVD), although embodiments are not limited thereto. The first circuit gate dielectric layer 222 may be formed of silicon oxide, and the first circuit gate electrode 225 may be formed of at least one of polycrystalline silicon or a metal silicide layer, but the present disclosure is not limited thereto.

Next, first spacer layers 224 may be formed on both sidewalls of the first circuit gate dielectric layer 222 and the first circuit gate electrode 225, and first source/drain regions 205 may be formed in the first substrate 201 on both sides of the first circuit gate electrode 225. According to example embodiments, the first spacer layer 224 may be formed of a plurality of layers. The first source/drain regions 205 may be formed by performing an ion implantation process (e.g., using the first circuit gate electrode 225 as an implantation mask).

First circuit contact plugs 270 among the first circuit interconnection structures may be formed by forming a portion of the first peripheral region insulating layer 290 and then partially etching and removing the first peripheral region insulating layer 290 and filling the removed portion with a conductive material. The term "filling" (or "fill," or like terms), as may be used herein, is intended to refer broadly to either completely filling a defined space (e.g., the removed portion of the first peripheral region insulating layer 290) or partially filling the defined space; that is, the defined space need not be entirely filled but may, for example, be partially filled or have voids or other spaces throughout. The first circuit interconnection lines 280 may be formed, for example, by depositing a conductive material and then patterning the conductive material. The first capacitor electrode 284P may be formed together with the second upper circuit interconnection lines 284, and may be formed to be horizontally spaced apart from the second upper circuit interconnection lines 284.

The first peripheral region insulating layer 290 may be formed of a plurality of insulating layers. The first peripheral region insulating layer 290 may be partially formed in each operation of forming the first circuit interconnection structure.

Referring to FIG. 9B, a first peripheral region insulating layer 290 may be further formed on the second upper circuit interconnection lines 284 and the first capacitor electrode 284P, and a first bonding insulating layer 299 may be formed.

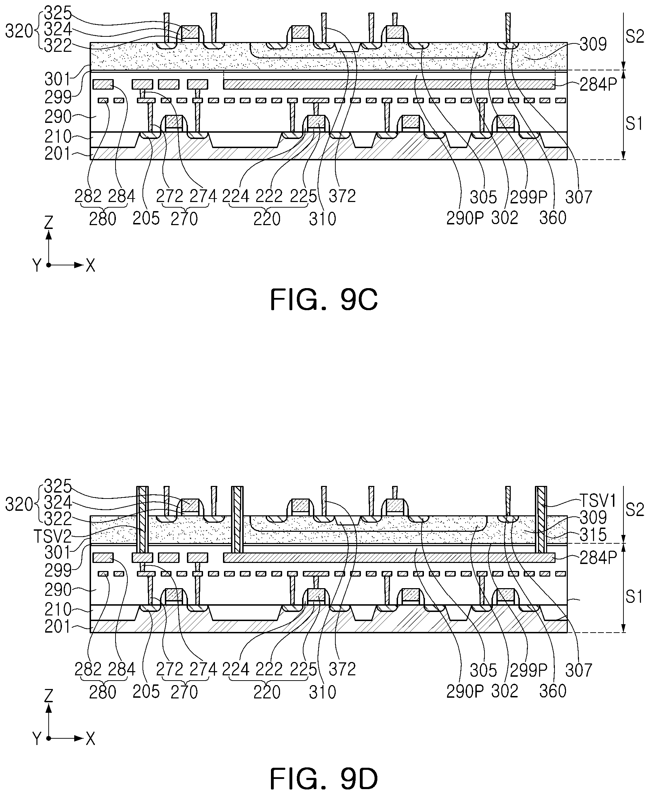

The first bonding insulating layer 299 may be a layer for bonding with a second substrate 301 of a second semiconductor structure S2 (see FIG. 9C). The first bonding insulating layer 299 may be, for example, SiCN, but the present disclosure is not limited thereto. The first peripheral region insulating layer 290 on the first capacitor electrode 284P and the first bonding insulating layer 299 on the first capacitor electrode 284P may form first and second capacitor dielectric regions 290P and 299P, respectively.

Through this operation, the first semiconductor structure S1 may be formed and a portion of the passive element structure PE (see FIG. 7) may be formed.

Referring to FIG. 9C, the second substrate 301 of the second semiconductor structure S2 may be bonded to the first semiconductor structure S1, and second circuit elements 320, second lower circuit contact plugs 372 and capacitor contact plug 360 may be formed on the second substrate 301.

By the same process as in the first semiconductor structure S1 described above, second device isolating layers 310 may be formed in the second substrate 301, and after forming a well region 302, second circuit elements 320 may be formed on the second substrate 301, and second source/drain regions 305 and contact regions 307 may be formed. The well region 302, the second source/drain regions 305, and the contact region 307 may be formed by, for example, an ion implantation process.

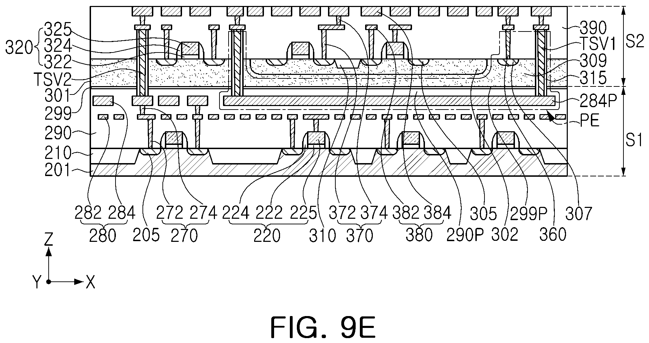

The second lower circuit contact plugs 372 and the capacitor contact plug 360 may be formed by forming a portion of the second peripheral region insulating layer 390 (see FIG. 9E) and then partially etching and removing the second peripheral region insulating layer 390 and filling the removed portion with a conductive material. The capacitor contact plug 360 may be formed together with the second lower circuit contact plugs 372.

Referring to FIG. 9D, first and second through-vias TSV1 and TSV2 may be formed.

First, via holes penetrating the second peripheral region insulating layer 390 (see FIG. 9E) and the second substrate 301 and exposing the second upper circuit interconnection line 284 and the first capacitor electrode 284P may be formed. Via insulating layers 315 may be formed in the via holes and filled with a conductive material to form first and second through-vias TSV1 and TSV2. The first through-vias TSV1 may be in contact with the first capacitor electrode 284P, and the second through-via TSV2 may be in contact with the second upper circuit interconnection line 284. In some example embodiments, the first and second through-vias TSV1 and TSV2 may be formed after forming a second lower circuit interconnection lines 382 (see FIG. 9E).

Through this operation, a passive element structure PE (see FIG. 8) may be formed.

Referring to FIG. 9E, a second circuit interconnection structure may be formed.

First, a second peripheral region insulating layer 390 may be further formed, and second circuit contact plugs 370 and second circuit interconnection lines 380 of the second circuit interconnection structure may be formed through the same process as in the first semiconductor structure S1 described above.

Through this operation, the second semiconductor structure S2 may be formed.

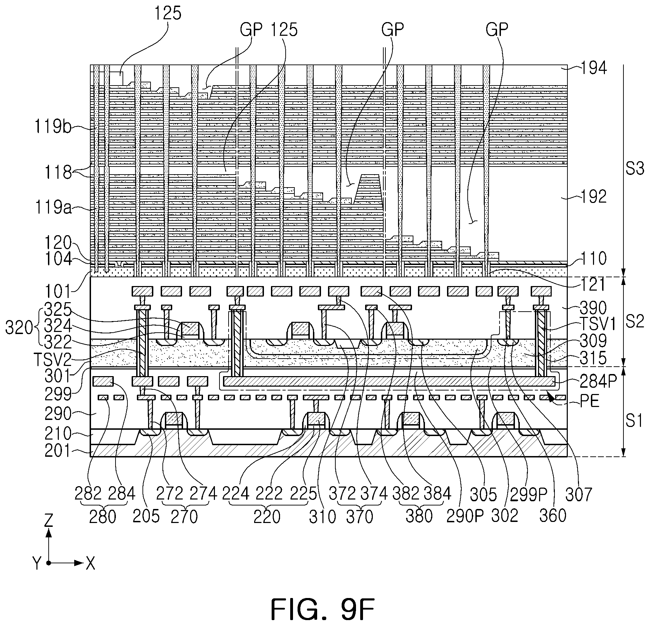

Referring to FIG. 9F, the third substrate 101 of the third semiconductor structure S3 may be bonded to the second semiconductor structure S2, a horizontal insulating layer 110 and a second horizontal conductive layer 104 may be formed, substrate insulating layers 121 may be formed, sacrificial insulating layers 118 and interlayer insulating layers 120 may be alternately stacked, a stepwise structure of the sacrificial insulating layers 118 and the interlayer insulating layers 120 may be formed, and first and second vertical sacrificial layers 119a and 119b may be formed.

The third substrate 101 may be bonded to the third peripheral region insulating layer 390. In some example embodiments, the third substrate 101 may be formed of, for example, polycrystalline silicon and may be formed in a CVD process. A plurality of insulating layers of the horizontal insulating layer 110 may be sequentially stacked in the Z-direction (i.e., vertically) on the third substrate 101. Some regions of the horizontal insulating layer 110 may be removed in a patterning process. The second horizontal conductive layer 104 may be formed on the horizontal insulating layer 110, and may be bent in a region in which the horizontal insulating layer 110 has been removed and may come into contact with the third substrate 101. The substrate insulating layers 121 may be formed to penetrate (i.e., extend) through the third substrate 101, the horizontal insulating layer 110, and the second horizontal conductive layer 104 in some regions including a region in which the cell contact plugs 170 of FIG. 7 are to be disposed.

Next, the sacrificial insulating layers 118 and the interlayer insulating layers 120 may be alternately stacked to form a lower mold structure. The lower mold structure may be formed at a height, relative to an upper surface of the third substrate 101, at which the first channel structures CH1 (see FIG. 7) are disposed. A relatively thick upper interlayer insulating layer 125 may be formed on the interlayer insulating layers 120. The sacrificial insulating layers 118 may be formed of a material different from the interlayer insulating layers 120. Next, a stepwise region GP may be formed by partially removing the sacrificial insulating layers 118 and the interlayer insulating layers 120 from an upper portion. The sacrificial insulating layers 118 may form a stepwise structure in predetermined units, and the sacrificial insulating layers 118 disposed in an uppermost portion of the sacrificial insulating layers 118 in the stepwise region GP may be exposed upwardly.

Next, a first cell region insulating layer 192 covering the lower mold structure may be formed, and first vertical sacrificial layers 119a penetrating through the lower mold structure may be formed. The first vertical sacrificial layers 119a may be formed in positions corresponding to the first channel structures CH1 and the cell contact plugs 170 of FIG. 7. The first vertical sacrificial layers 119a may include, for example, polycrystalline silicon, a carbon-based material, or a metal material.

Next, an upper mold structure may be formed on the lower mold structure in the same manner, and second vertical sacrificial layers 119b may be formed. The second vertical sacrificial layers 119b may be formed to be respectively connected to the first vertical sacrificial layers 119a.

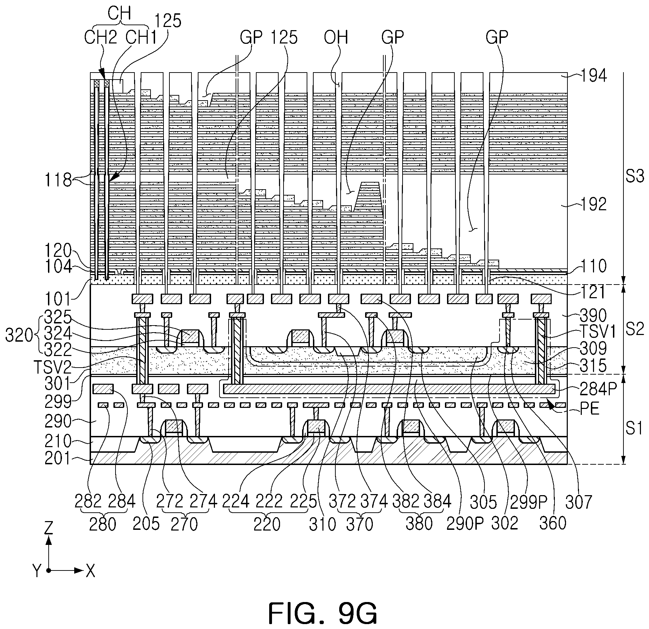

Referring to FIG. 9G, channel structures CH and cell contact holes OH may be formed.

First, the channel structures CH may be formed by removing a portion of the first and second vertical sacrificial layers 119a and 119b (see FIG. 9F) to form hole-shaped channel holes, and then depositing a channel layer, a channel dielectric layer, or the like.

Next, the cell contact holes OH may be formed by removing another portion of the first and second vertical sacrificial layers 119a and 119b (see FIG. 9F), and further removing the second peripheral region insulating layer 390 exposed through bottom surfaces thereof. Second circuit interconnection lines 380 may be exposed through bottom surfaces of the cell contact holes OH.

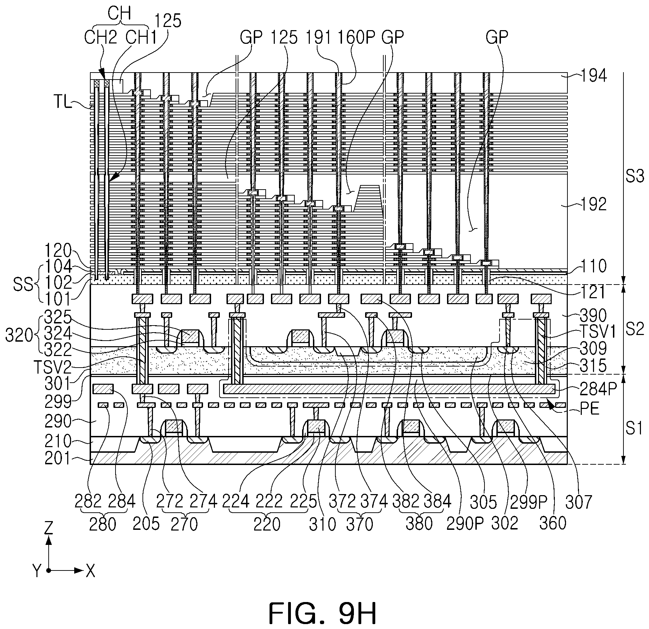

Referring to FIG. 9H, preliminary contact insulating layers 160P and vertical sacrificial layers 191 may be formed in the cell contact holes OH, first horizontal conductive layer 102 may be formed, and the sacrificial insulating layers 118 (see FIG. 9G) may be removed.

First, a portion of the sacrificial insulating layers 118 exposed through the cell contact holes OH (see FIG. 9G) may be removed. Tunnel portions may be formed by removing the sacrificial insulating layers 118 by a predetermined length around the cell contact holes OH. In one stepwise region GP, the tunnel portions may be formed to have a relatively short length in a sacrificial insulating layer 118 in an uppermost portion, and may be formed to have a relatively long length in sacrificial insulating layers 118 disposed therebelow.

Next, an insulating material may be deposited in the cell contact holes OH and the tunnel portions to form preliminary contact insulating layers 160P. The preliminary contact insulating layers 160P may be formed on sidewalls of the cell contact holes OH and fill the tunnel portions. The preliminary contact insulating layers 160P may not completely fill the tunnel portions in an uppermost portion of the stepwise regions GP. The vertical sacrificial layers 191 may fill the cell contact holes OH and the tunnel portions in the uppermost portion thereof. The vertical sacrificial layers 191 may include a material different from a material of the preliminary contact insulating layers 160P, and may include, for example, polycrystalline silicon.

Next, openings extending to the third substrate 101 by penetrating through the sacrificial insulating layers 118 and the interlayer insulating layers 120 may be formed in a region not illustrated. Next, the horizontal insulating layer 110 may be selectively removed through the openings, and a conductive material may be deposited in the region from which the horizontal insulating layer 110 has been removed, thereby forming the first horizontal conductive layer 102.

Next, the sacrificial insulating layers 118 may be selectively removed with respect to the interlayer insulating layers 120, the second horizontal conductive layer 104, and the preliminary contact insulating layers 160P, using, for example, wet etching. As a result, tunnel portions TL may be formed in regions in which the sacrificial insulating layers 118 have been removed.

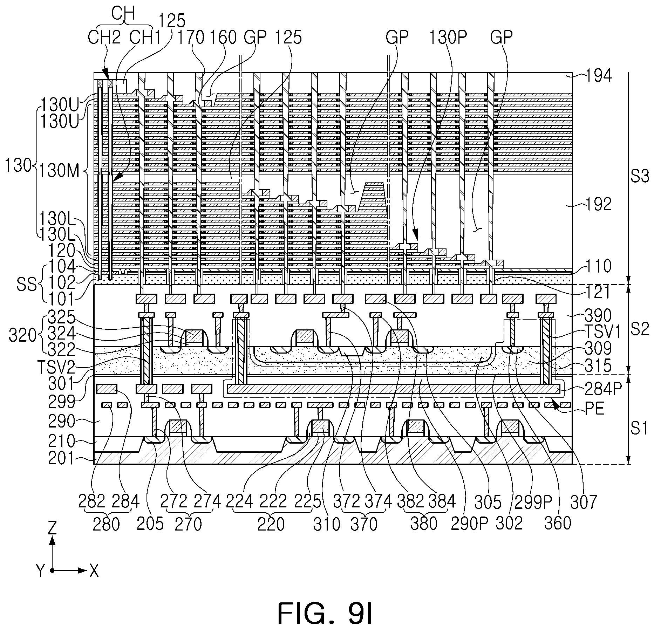

Referring to FIG. 9I, gate electrodes 130 and cell contact plugs 170 may be formed.

The gate electrodes 130 may be formed by depositing a conductive material on the tunnel portions TL (see FIG. 9H). The conductive material may include metal, polycrystalline silicon, or metal silicide material.

Next, the vertical sacrificial layers 191 (see FIG. 9H) within the cell contact holes OH may be removed. The vertical sacrificial layers 191 may be selectively removed with respect to the interlayer insulating layers 120 and the gate electrodes 130. A portion of the preliminary contact insulating layers 160P exposed after the vertical sacrificial layers 191 have been removed may also be removed. In this case, all of the preliminary contact insulating layers 160P may be removed from the pad regions 130P, and may remain therebelow, thereby forming contact insulating layers 160.

The cell contact plugs 170 may be formed by depositing a conductive material in the cell contact holes OH. The cell contact plugs 170 may be formed to have horizontal extension portion extending horizontally from the pad regions 130P, and may thereby be physically and electrically connected to the gate electrodes 130.

Next, referring to FIG. 7, studs 180 and cell interconnection lines 185 connected to the cell contact plugs 170 and upper ends of the channel structures CH may be formed, thereby forming the third semiconductor structure S3 as well as manufacturing the semiconductor device 100d.

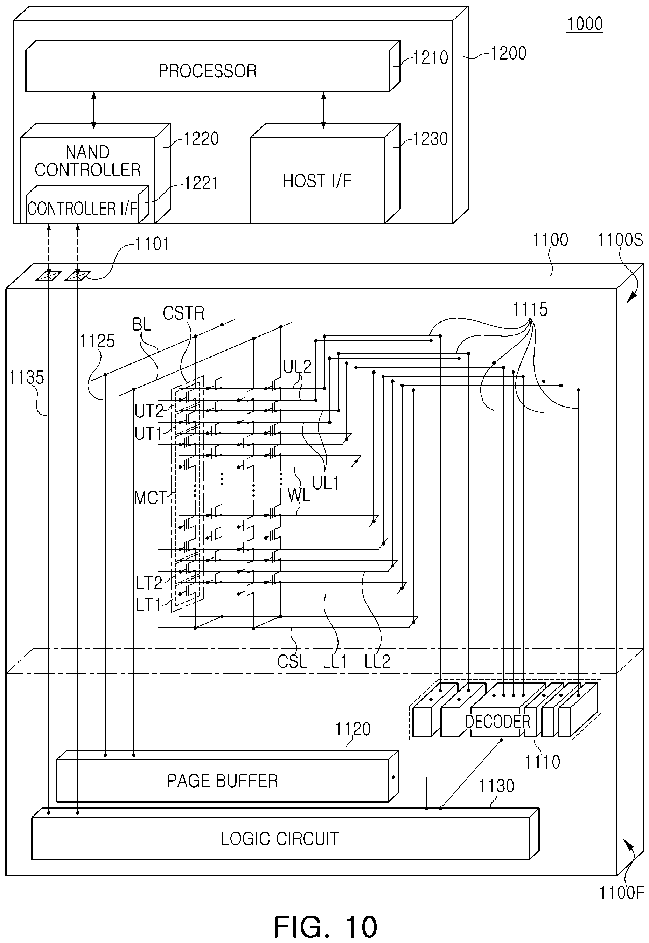

FIG. 10 is a block diagram schematically illustrating a data storage system including a semiconductor device according to example embodiments.

Referring to FIG. 10, a data storage system 1000 may include a semiconductor device 1100 and a controller 1200 electrically connected to the semiconductor device 1100. The data storage system 1000 may be a storage device including one or a plurality of semiconductor devices 1100, or may be an electronic device including a storage device. For example, the data storage system 1000 may be a solid state drive device (SSD) device, a universal serial bus (USB) device, a computing system, a medical device, or a communication device, which include one or a plurality of semiconductor devices 1100.

The semiconductor device 1100 may be a non-volatile memory device, and may be, for example, a NAND flash memory device described above with reference to FIGS. 7 and 8. The semiconductor device 1100 may include a first structure 1100F and a second structure 1100S on the first structure 1100F. In example embodiments, the first structure 1100F may be disposed next to the second structure 1100S. The first structure 1100F may be a peripheral circuit structure including a decoder circuit 1110, a page buffer 1120, and a logic circuit 1130. The second structure 1100S may be a memory cell structure including one or more bit lines BL, a common source line CSL, word lines WL, first and second gate upper lines UL1 and UL2, first and second gate lower lines LL1 and LL2, and memory cell strings CSTR between the bit lines BL and the common source line CSL.

In the second structure 1100S, each of the memory cell strings CSTR may include lower transistors LT1 and LT2 adjacent to the common source line CSL, upper transistors UT1 and UT2 adjacent to a corresponding one of the bit lines BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be variously changed according to example embodiments.

In example embodiments, the upper transistors UT1 and UT2 may include string selection transistors, and the lower transistors LT1 and LT2 may include a ground selection transistor. The gate lower lines LL1 and LL2 may be gate electrodes of the lower transistors LT1 and LT2, respectively. The word lines WL may be gate electrodes of the memory cell transistors MCT, and the gate upper lines UL1 and UL2 may be gate electrodes of the upper transistors UT1 and UT2, respectively.

In example embodiments, the lower transistors LT1 and LT2 may include a lower erase control transistor LT1 and a ground selection transistor LT2 connected in series. The upper transistors UT1 and UT2 may include a string select transistor UT1 and an upper erase control transistor UT2 connected in series. At least one of the lower erase control transistor LT1 or the upper erase control transistor UT2 may be used in an erase operation of deleting data stored in the memory cell transistors MCT using a GIDL phenomenon.

The common source line CSL, the first and second gate lower lines LL1 and LL2, the word lines WL, and the first and second gate upper lines UL1 and UL2 may be electrically connected to the decoder circuit 1110 through first connection interconnection lines 1115 extending from the first structure 1100F to the second structure 1100S. The bit lines BL may be electrically connected to the page buffer 1120 through second connection interconnection lines 1125 extending from the first structure 1100F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through one or more input/output pads 1101 electrically connected to the logic circuit 1130. The input/output pads 1101 may be electrically connected to the logic circuit 1130 through one or more input/output connection interconnection lines 1135 extending from the first structure 1100F to the second structure 1100S.

The controller 1200 may include a processor 1210, a NAND controller 1220, and a host interface (I/F) 1230. According to example embodiments, the data storage system 1000 may include a plurality of semiconductor devices 1100, and in this case, the controller 1200 may control a plurality of semiconductor devices 1100.

The processor 1210 may control an overall operation of the data storage system 1000, including the controller 1200. The processor 1210 may operate according to predetermined firmware, and may control the NAND controller 1220 to access the semiconductor device 1100. The NAND controller 1220 may include a controller interface 1221 configured to process communication with the semiconductor device 1100. Through the controller interface 1221, control commands for controlling the semiconductor device 1100, data to be recorded in the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When receiving the control commands from an external host through the host interface 1230, the processor 1210 may control the semiconductor device 1100 in response to the control commands.

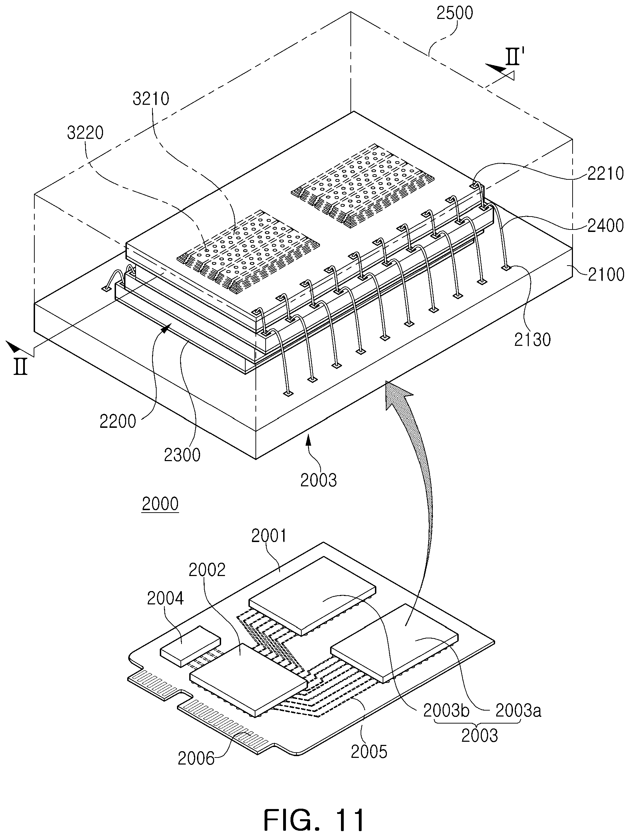

FIG. 11 is a perspective view schematically illustrating a data storage system including a semiconductor device according to an example embodiment.

Referring to FIG. 11, a data storage system 2000 according to an example embodiment of the present disclosure may include a main board 2001, a controller 2002 provided on the main board 2001, one or more semiconductor packages 2003, and a DRAM 2004. The semiconductor package 2003 and the DRAM 2004 may be connected to the controller 2002 through interconnection patterns 2005 formed on the main board 2001.

The main board 2001 may include a connector 2006 including a plurality of pins coupled to an external host. The number and arrangement of the plurality of pins in the connector 2006 may vary depending on the communication interface between the data storage system 2000 and the external host. In example embodiments, the data storage system 2000 may communicate with an external host to any one of the interfaces such as Universal Serial Bus USB), Peripheral Component Interconnect Express (PCI-Express), Serial Advanced Technology Attachment (SATA), and M-Phy for Universal Flash Storage (UFS). In example embodiments, the data storage system 2000 may operate with power supplied from the external host through the connector 2006. The data storage system 2000 may further include a Power Management Integrated Circuit (PMIC) configured to distribute power supplied from the external host to the controller 2002 and the semiconductor package 2003.

The controller 2002 may record data in the semiconductor package 2003 or read data from the semiconductor package 2003, and may improve operating speed of the data storage system 2000.

The DRAM 2004 may be a buffer memory to alleviate a speed difference between the semiconductor package 2003 which is a data storage space and the external host. The DRAM 2004 included in the data storage system 2000 may also operate as a type of cache memory, and may provide a space for temporarily storing data in control operations for the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b which are spaced apart from each other. Each of the first and second semiconductor packages 2003a and 2003b may include a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of each of the semiconductor chips 2200, a connection structure 2400 that electrically connects the semiconductor chips 2200 and the package substrate 2100, and a molding layer 2500 covering the semiconductor chips 2200 and the connection structure 2400 on the package substrate 2100.

The package substrate 2100 may be a printed circuit board including package upper pads 2130. Each of the semiconductor chips 2200 may include an input/output pad 2210. The input/output pad 2210 may correspond to the input/output pad 1101 of FIG. 10. Each of the semiconductor chips 2200 may include gate stack structures 3210 and channel structures 3220. Each of the semiconductor chips 2200 may include the semiconductor device described above with reference to FIG. 7 or 8.

In example embodiments, the connection structure 2400 may be a bonding wire electrically connecting the input/output pad 2210 and package upper pads 2130 of the package. Accordingly, in each of the first and second semiconductor packages 2003a and 2003b, the semiconductor chips 2200 may be electrically connected to each other using a bonding wire method and may be electrically connected to the package upper pads 2130 of the package substrate 2100. According to example embodiments, in each of the first and second semiconductor packages 2003a and 2003b, the semiconductor chips 2200 may be electrically connected to each other by a connection structure including a through-silicon via (TSV), instead of the bonding wire-type connection structure 2400.

In example embodiments, the controller 2002 and the semiconductor chips 2200 may be included in one package. In an example embodiment, the controller 2002 and the semiconductor chips 2200 may be mounted on an additional interposer substrate different from the main substrate 2001, and the controller 2002 and the semiconductor chips 2200 may be connected to each other through an interconnection line formed on the interposer substrate.

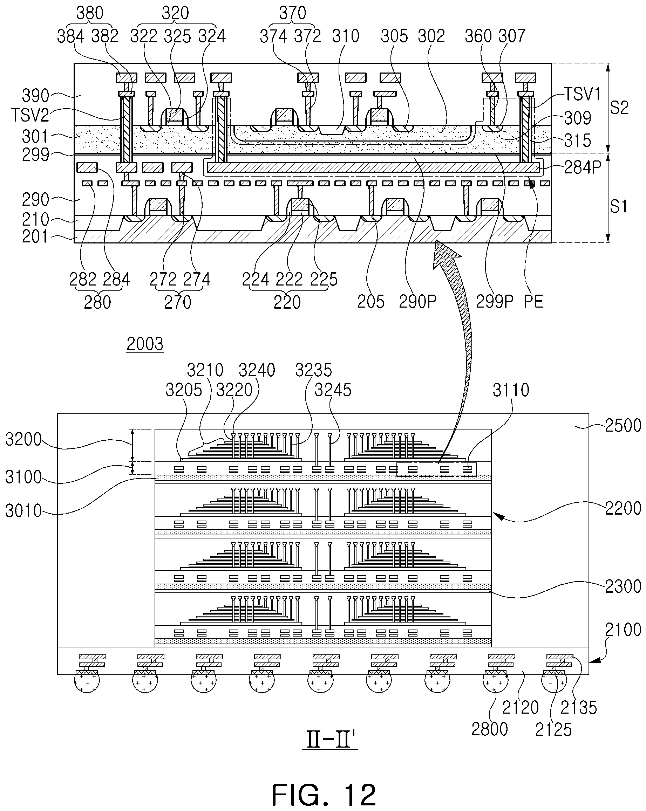

FIG. 12 is a cross-sectional view schematically illustrating a semiconductor package according to an example embodiment. FIG. 12 illustrates an example embodiment of the semiconductor package 2003 of FIG. 11 and conceptually illustrates a region in which the semiconductor package 2003 of FIG. 11 is cut along cutting line II-II' of FIG. 11.

Referring to FIG. 12, in the semiconductor package 2003, the package substrate 2100 may be a printed circuit board. The package substrate 2100 may include a package substrate body 2120, package upper pads 2130 (see FIG. 11) disposed on an upper surface of the package substrate body 2120, upper pads 2125 disposed on or exposed through a lower surface of the package substrate body 2120, and internal interconnection lines 2135 electrically connecting the upper pads 2130 and the lower pads 2125 inside the package substrate body 2120. The lower pads 2125 may be electrically connected to the interconnection patterns 2005 of the main board 2001 of the data storage system 2000 as illustrated in FIG. 11 through conductive connectors 2800.

Each of the semiconductor chips 2200 may include a semiconductor substrate 3010, and a first structure 3100 and a second structure 3200 that are sequentially stacked on the semiconductor substrate 3010 in the vertical direction. The first structure 3100 may include a peripheral circuit region including peripheral interconnection lines 3110. The second structure 3200 may include a common source line 3205, a gate stack structure 3210 on the common source line 3205, channel structures 3220 penetrating through the gate stack structure 3210, bit lines 3240 electrically connected to the channel structures 3220, and contact plugs 3235 electrically connected to the word lines WL (see FIG. 10) of the gate stack structure 3210. As described above with reference to FIGS. 7 and 8, in each of the semiconductor chips 2200, the first structure 3100 may include first and second semiconductor structures S1 and S2 and a passive element structure PE. A first capacitor electrode 284P of the passive element structure PE may be disposed below the second substrate 301, and may be connected to the first through-vias TSV1 penetrating through the second substrate 301.

Each of the semiconductor chips 2200 may include a through-interconnection line 3245 electrically connected to the peripheral interconnection lines 3110 of the first structure 3100 and extending into the second structure 3200. The through-interconnection line 3245 may be disposed outside the gate stack structure 3210 and may be further disposed to penetrate through the gate stack structure 3210. Each of the semiconductor chips 2200 may further include an input/output pad 2210 (see FIG. 11) electrically connected to the peripheral interconnection lines 3110 of the first structure 3100.

The terms "upper", "middle", "lower" may refer to relative positions along a particular direction (e.g. a vertical direction). Similar, the terms "above" and "below" may refer to relative positions along a particular direction (e.g. a vertical direction). Various directions (e.g. vertical direction, horizontal direction, etc.) may be defined relative to the structure of the devices described herein. It will be appreciated that these directions do not necessarily imply any particular orientation of the device in use. The terms "upper", "middle", "lower", etc. may be replaced with terms, such as "first", "second", third" to be used to describe relative positions of elements. The terms "first", "second", third" may be used to describe various elements but the elements are not limited by the terms and a "first element" may be referred to as a "second element". Alternatively or additionally, the terms "first", "second", "third", etc. may be used to distinguish components from each other and do not limit the present disclosure. For example, the terms "first", "second", "third", etc. may not necessarily involve an order or a numerical meaning of any form.

Embodiments are set out in the following Clauses:
Clause 1. A semiconductor device, comprising:
   a first semiconductor structure including a first substrate, first circuit elements on the first substrate, first circuit interconnection lines on the first circuit elements, and a first peripheral region insulating layer on the first circuit interconnection lines;
   a second semiconductor structure including a first region of a second substrate on the first semiconductor structure, second circuit elements on the first region of the second substrate, and second circuit interconnection lines on the second circuit elements;
   a capacitor structure including a first capacitor electrode spaced apart from the first circuit interconnection lines on a lower surface of the second substrate, a second region of the second substrate facing the first capacitor electrode, and a first through-via penetrating through the second substrate and connected to the first capacitor electrode; and
   a third semiconductor structure including a third substrate on the second semiconductor structure and the capacitor structure, and memory cells on the third substrate.
Clause 2. The semiconductor device of Clause 1, wherein the capacitor structure further includes a capacitor contact plug connected to the second region on the second region of the second substrate.
Clause 3. The semiconductor device of Clause 2, wherein the first through-via and the capacitor contact plug are configured to be applied with different voltages.
Clause 4. The semiconductor device of any preceding Clause, wherein the capacitor structure further includes a capacitor dielectric region between the first capacitor electrode and the second region of the second substrate.
Clause 5. The semiconductor device of any preceding Clause, wherein in plan view, the first through-via overlaps the first capacitor electrode.
Clause 6. The semiconductor device of any preceding Clause, wherein in plan view, the first capacitor electrode overlaps at least a portion of the second circuit elements.
Clause 7. The semiconductor device of any preceding Clause, wherein an entire lower surface of the first capacitor electrode is covered with the first peripheral region insulating layer.
Clause 8. The semiconductor device of any preceding Clause, wherein the first through-via is connected to each end of the first capacitor electrode in one direction.
Clause 9. The semiconductor device of any preceding Clause, wherein the second semiconductor structure further includes second through-vias penetrating through the second substrate, connected to the first circuit interconnection lines, and electrically connected to the first circuit elements.
Clause 10. The semiconductor device of any preceding Clause, wherein the first semiconductor structure further includes a first bonding insulating layer on the first peripheral region insulating layer, and
   the first through-via further penetrates through the first bonding insulating layer.
Clause 11. The semiconductor device of any preceding Clause, wherein the first capacitor electrode includes a same material as first circuit interconnection lines at least on an uppermost portion, among the first circuit interconnection lines.
Clause 12. The semiconductor device of any preceding Clause, wherein the first region of the second substrate includes source/drain regions of the second circuit elements and a well region surrounding the source/drain regions.
Clause 13. The semiconductor device of any preceding Clause, wherein the third semiconductor structure further includes:
   gate electrodes stacked on the third substrate and spaced apart from each other in a direction, perpendicular to an upper surface of the third substrate; and
   channel structures penetrating through the gate electrodes and extending vertically.
Clause 14. A semiconductor device, comprising:
   a first substrate:
   first circuit elements on the first substrate;
   circuit interconnection lines on the first circuit elements;
   a passive element structure including a conductive layer spaced apart from the circuit interconnection lines;
   a peripheral region insulating layer on the circuit interconnection lines and the conductive layer;
   a second substrate on the peripheral region insulating layer;
   first through-vias penetrating through the second substrate and connected to the conductive layer; and
   second through-vias passing through the second substrate and connected to the circuit interconnection lines.
Clause 15. The semiconductor device of Clause 14, wherein an entire lower surface of the conductive layer is covered with the peripheral region insulating layer.
Clause 16. The semiconductor device of Clause 14 or Clause 15, wherein the passive element structure includes at least one of a resistor, an inductor, or a capacitor.
Clause 17. The semiconductor device of any of Clauses 14-16, wherein upper surfaces of the first through-vias are on a same level as upper surfaces of the second through-vias.
Clause 18. The semiconductor device of any of Clauses 14-17, further comprising:
   second circuit elements on the second substrate,
   wherein the conductive layer vertically overlaps at least one of the second circuit elements.
Clause 19. A data storage system comprising:
   a semiconductor storage device including:
      a first semiconductor structure including a first substrate, first circuit elements on the first substrate, and a first circuit interconnection structure on the first circuit elements;
      a second semiconductor structure including a second substrate on the first semiconductor structure, second circuit elements on the second substrate, and a second circuit interconnection structure on the second circuit elements;
      a third semiconductor structure on the second semiconductor structure and including memory cells;
      a passive element structure including a conductive layer on a lower surface of the second substrate and a through-via penetrating through the second substrate and connected to the conductive layer; and
      an input/output pad electrically connected to the first and second circuit elements; and
   a controller electrically connected to the semiconductor storage device through the input/output pad and configured to control the semiconductor storage device.
Clause 20. The data storage system of Clause 19, wherein the conductive layer is spaced apart from the first circuit interconnection structure.

The present disclosure is not limited to the above-described embodiments and the accompanying drawings but is defined by the appended claims. Therefore, those of ordinary skill in the art may make various replacements, modifications, changes, or combinations of embodiments without departing from the scope of the present disclosure defined by the appended claims, and these replacements, modifications, changes, or combinations of embodiments should be construed as being included in the scope of the present disclosure.

## Claims

1. A semiconductor device, comprising:
a first semiconductor structure including a first substrate, first circuit elements on the first substrate, first circuit interconnection lines on the first circuit elements, and a first peripheral region insulating layer on the first circuit interconnection lines;
a second semiconductor structure including a first region of a second substrate on the first semiconductor structure, second circuit elements on the first region of an upper surface of the second substrate, and second circuit interconnection lines on the second circuit elements;
a capacitor structure including a first capacitor electrode spaced apart from the first circuit interconnection lines on a lower surface of the second substrate, opposite the upper surface of the second substrate, in a vertical direction perpendicular to the lower surface of the second substrate, a second region of the second substrate facing the first capacitor electrode, and a first through-via extending in the second substrate and electrically connected to the first capacitor electrode; and
a third semiconductor structure including a third substrate on the second semiconductor structure and the capacitor structure, and memory cells on the third substrate.

2. The semiconductor device of claim 1, wherein the capacitor structure further includes a capacitor contact plug on and electrically connected to the second region of the second substrate.

3. The semiconductor device of claim 2, wherein the first through-via and the capacitor contact plug are configured to receive different voltages.

4. The semiconductor device of any preceding claim, wherein the capacitor structure further includes a capacitor dielectric region between the first capacitor electrode and the second region of the second substrate.

5. The semiconductor device of any preceding claim, wherein in plan view, the first through-via at least partially overlaps the first capacitor electrode.

6. The semiconductor device of any preceding claim, wherein in plan view, the first capacitor electrode overlaps at least a portion of the second circuit elements.

7. The semiconductor device of any preceding claim, wherein the first peripheral region insulating layer is on an entire lower surface of the first capacitor electrode.

8. The semiconductor device of any preceding claim, wherein the first through-via is one of a plurality of through-vias electrically connected to respective opposing ends of the first capacitor electrode in a horizontal direction parallel to the lower surface of the second substrate.

9. The semiconductor device of any preceding claim, wherein the second semiconductor structure further includes second through-vias extending in the second substrate, connected to the first circuit interconnection lines, and electrically connected to the first circuit elements.

10. The semiconductor device of any preceding claim, wherein the first semiconductor structure further includes a first bonding insulating layer on the first peripheral region insulating layer, and
the first through-via further extends in the first bonding insulating layer.

11. The semiconductor device of any preceding claim, wherein the first capacitor electrode includes a same material as at least an uppermost portion of the first circuit interconnection lines.

12. The semiconductor device of any preceding claim, wherein the first region of the second substrate includes source/drain regions of the second circuit elements and a well region extending around the source/drain regions.

13. The semiconductor device of any preceding claim, wherein the third semiconductor structure further includes:
gate electrodes stacked on the third substrate and spaced apart from each other in the vertical direction; and
channel structures extending in the vertical direction in the gate electrodes.

14. A data storage system, comprising:
the semiconductor device of any one of the preceding claims, the semiconductor device further including an input/output pad electrically connected to the first and second circuit elements; and
a controller electrically connected to the semiconductor device through the input/output pad and configured to control the semiconductor device.
